# EUROPEAN PATENT SPECIFICATION

(11) **EP 1 708 258 B1**
(45) Date of publication and mention of the grant of the patent: **09.07.2008**
(21) Application number: 05765475.8
(22) Date of filing: 05.07.2005
(51) Int. Cl.: H05K 3/34, H01L 23/498

(54) **COMPOSITE CERAMIC SUBSTRATE**
ZUSAMMENGESETZTES KERAMISCHES SUBSTRAT
SUBSTRAT DE CÉRAMIQUE COMPOSITE

(30) Priority: 08.09.2004 JP 2004261692
(43) Date of publication of application: 04.10.2006
(73) Proprietor: MURATA MANUFACTURING CO., LTD., Nagaokakyo-shi, Kyoto 617-8555 (JP)
(72) Inventor: OGAWA, Nobuaki, c/o Murata Manufacturing Co., Ltd., Nagaokakyo-shi, Kyoto 617-8555 (JP)
(74) Representative: Stöckeler, Ferdinand
(86) International application number: PCT/JP2005/012403
(87) International publication number: WO 2006/027888

(56) References cited:
- WO-A-97/35343
- GB-A- 1 263 126
- JP-A- 2000 101 348
- US-A- 5 107 329
- US-B1- 6 184 587

## Description

The present invention relates to composite ceramic substrates, more specifically, relates to composite ceramic substrates having circuit elements built-in and having laminated ceramic substrates and resin layers.

Conventional technologies in this field include a laminated electronic component disclosed in Patent Document 1 and a high-frequency semiconductor device disclosed in Patent Document 2.

The laminated electronic component disclosed in Patent Document 1 is formed by laminating a plurality of insulating sheets so as to interpose a circuit element therebetween and to constitute a laminate having opposing main faces and side faces connecting the main faces; preparing a plurality of external electrodes on the outer surfaces of the laminate so as to be electrically connected to the circuit element; and forming a recess at least at the substantially central portion of a face at a circuit board side of the laminate when the laminated electronic component is mounted on the circuit board via the external electrodes. With such a recess formed on the face at the circuit board (specifically, a flexible printed-circuit board) side of the laminate, even if the circuit board is bent, the bent face of the printed-circuit board does not come into contact with the face of the circuit board side of the laminate. Therefore, the pressing-up force against the laminate is avoided. Thus, detachment of the laminate from the printed-circuit board and breakage of the laminate are prevented.

The high-frequency semiconductor device disclosed in Patent Document 2 includes a composite resin material layer formed on the bottom of a ceramic substrate. The composite resin material layer is made of an epoxy resin and an inorganic filler material and has a flat bottom on which electrodes for external connection are formed. Semiconductor elements and passive components, which are connected to the ceramic substrate, are embedded in the inside of the composite resin material layer. With such a structure, the bottom face of the board can be used as a mounting area to improve the mounting density. Furthermore, mechanical properties and reliability in moisture resistance are improved by embedding the semiconductor elements and the passive components in the composite resin material layer.

Patent Document 1: Japanese Unexamined Patent Application Publication No. 9-186042

Patent Document 2: Japanese Unexamined Patent Application Publication No. 2003-124435

The laminated electronic component disclosed in Patent Document 1 can avoid the pressing-up force by forming the recess at the central portion, but the entire laminate bends corresponding to bending of the printed-circuit board. It is not a problem when surface-mounted components are not mounted on the top face nor both top and bottom faces of the laminate. However, when the surface-mounted components such as passive components and active components are mounted on the laminate, these surface-mounted components cannot correspond to the bending of the laminate, which may cause disconnection of terminals for external connection of the surface-mounted components from the electrodes on the surface of the laminate. Thus, breaking of wire may occur.

In the high-frequency semiconductor device disclosed in Patent Document 2, the board component can be decreased in size by mounting the surface-mounted components such as active components and passive components on the bottom or top face of the ceramic substrate. However, the ceramic substrate in this case also bends corresponding to the bending of the printed-circuit board. Therefore, since the surface-mounted components cannot correspond to the bending of the ceramic substrate, the terminals for external connection of the surface-mounted components are disconnected from the electrodes on the surface of the laminate to cause breaking of wire as in the case of the laminated electronic component of Patent Document 1; which is a problem

JP 2000-101348 A discloses a package for electronic components comprising a flat ceramic board whose one side has a wiring pattern, electronic components mounted on the wiring pattern of the ceramic board, and a cap that is made of an organic group board material and configured in a cave shape. An opening of the cave cap is enclosed by the ceramic board, so that the electronic components are placed in the opening of the cap. External terminals for mount are formed to an outer bottom face of the cap and the external terminals are connected electrically to the electronic components via the wiring pattern of the ceramic board and conductors provided to the cap.

It is the object of the invention to provide a composite ceramic assembly which can prevent breaking wire or detachment caused by disconnection of the composite ceramic substrate from a motherboard arisen from bending of the motherboard and, simultaneously, can prevent breaking of wire of the composite ceramic substrate itself and damage of surface-mounted components caused by disconnection between the surface-mounted components and the board.

This object is achieved by a composite ceramic assembly according to claim 1.

A composite ceramic assembly according to the present invention includes a ceramic substrate mounted with surface-mounted component, an external terminal electrode connected to a wiring pattern formed on the ceramic substrate, a convex leg portion formed of resin such that an end face supports the external terminal electrode, and a via-hole conductor formed in the leg portion and connecting the external terminal electrode and the wiring pattern.

In a composite ceramic assembly according to a first aspect of the present invention, the surface-mounted component is mounted on a first main face and/or a second main face of the ceramic substrate and the convex leg portion is disposed on the second main face of the ceramic substrate.

In a composite ceramic assembly according to a second aspect of the present invention, the convex leg portion is disposed at the periphery of the second main face of the ceramic substrate.

In a composite ceramic assembly according to a third aspect of the present invention, a plurality of the external terminal electrodes is supported by the end face of a single convex leg portion.

In a composite ceramic assembly, according to a fourth aspect of the present invention, the external terminal electrodes are not disposed at corners of the second main face of the ceramic substrate.

In a composite ceramic assembly according to a fifth aspect of the present invention, the corners are lower than the height where the external terminal electrodes are disposed.

In a composite ceramic assembly according to a sixth aspect of the present invention, the surface-mounted components mounted on the second main face are mounted between the convex leg portions.

In a composite ceramic assembly according to an seventh aspect of the present invention, the surface-mounted component is supported with resin that are the same as that forming the convex leg portion.

In a composite ceramic assembly according to an eighth aspect of the present invention, a round portion is formed between the convex leg portion and the resin coating the surface-mounted components.

In a composite ceramic assembly according to a minth aspect of the present invention, the surface of the resin coating the surface-mounted components has a slit.

In a composite ceramic assembly according to a tenth aspect of the present invention, an edge of the convex leg portion is formed into a rounded shape.

In a composite ceramic assembly according to an eleventh aspect of the present invention, the via-hole conductor is formed with conductive resin having flexibility.

In a composite ceramic assembly according to a twelfth aspect of the present invention, the ceramic substrate is a multilayer ceramic substrate formed by laminating a plurality of low temperature co-fired ceramic layers.

In a composite ceramic assembly according to a thirteenth aspect of the present invention, the surface-mounted component has external terminal electrodes in an array.

According to the present invention a composite ceramic assembly is provided which can prevent breaking wire or detachment caused by disconnection of the composite ceramic substrate from a motherboard arisen from bending of the motherboard and, simultaneously, can prevent breaking of wire of the composite ceramic substrate itself and damage of surface-mounted component caused by disconnection between the surface-mounted component and the board.

### Brief Description of the Drawings

Figs. 1 (a) to (c) are each a cross-sectional view of a composite ceramic substrate according to an embodiment of the present invention, (a) is a view showing a state after the composite ceramic substrate is mounted on a motherboard, (b) is a view showing a state when the motherboard after the mounting is bent, and (c) is a view showing a state of breaking of wire in a conventional composite ceramic substrate.
Figs. 2 (a) to (e) are process drawings showing substantial parts of manufacturing of the composite ceramic substrate shown in Fig. 1.
Figs. 3 (a) and (b) are each a cross-sectional view of a composite ceramic substrate according to another embodiment of the present invention.
Figs. 4 (a) and (b) are each a cross-sectional view of a composite ceramic substrate according to another embodiment of the present invention, (a) is a cross-sectional view of the composite ceramic substrate, and (b) is a schematic cross-sectional view showing the bonding relationship between a conventional multilayer ceramic substrate and surface-mounted components.
Fig. 5 is a cross-sectional view of a composite ceramic substrate according to another embodiment of the present invention.
Figs. 6 (a) and (b) are each a cross-sectional view of a composite ceramic substrate according to another embodiment of the present invention, and (c) and (d) are enlarged cross-sectional views showing portions defined by circles of (b).
Figs. 7 (a) and (b) are each a perspective view from the motherboard side of the composite ceramic substrate shown in (a) of Fig. 6, and (b) is a perspective view corresponding to (a) of a modified example of the leg portions.
Figs. 8 (a) and (b) are each a perspective view from the motherboard side of a modified example of the leg portions of the composite ceramic substrate shown in (a) of Fig. 6.
Figs. 9 (a) and (b) are each a perspective view from the motherboard side of a modified example of the leg portions and the external terminal electrodes of the composite ceramic substrate shown in (a) of Fig. 6.
Fig. 10 is a perspective view from the motherboard side of a modified example of the leg portions and the external terminal electrodes of the composite ceramic substrate shown in (a) of Fig. 6.
Fig. 11 is a cross-sectional view of a composite ceramic substrate according to another embodiment of the present invention.
Fig. 12 is a cross-sectional view of a composite ceramic substrate according to another embodiment of the present invention.
Fig. 13 is a cross-sectional view of a composite ceramic substrate having a cavity-type multilayer ceramic substrate according to another embodiment of the present invention.
Fig. 14 is a cross-sectional view of a composite ceramic substrate having a cavity-type multilayer ceramic substrate according to another embodiment of the present invention.
Fig. 15 is a cross-sectional view of a composite ceramic substrate having a cavity-type multilayer ceramic substrate according to another embodiment of the present invention.

### Reference Numerals

10, 10A, 10B, 10C, 10D, 10E, 10F, 10G, 10H: composite ceramic substrate
11, 11B: surface-mounted component
12: multilayer ceramic substrate (ceramic substrate)
12A: ceramic layer (low temperature co-fired ceramic layer)
13: wiring pattern
14: external terminal electrode
15: leg portion
15A: resin portion (resin)
15B: via-hole conductor
18: composite resin layer (resin)
18A: slit
20: motherboard
21: surface electrode

### Best Mode for Carrying Out the Invention

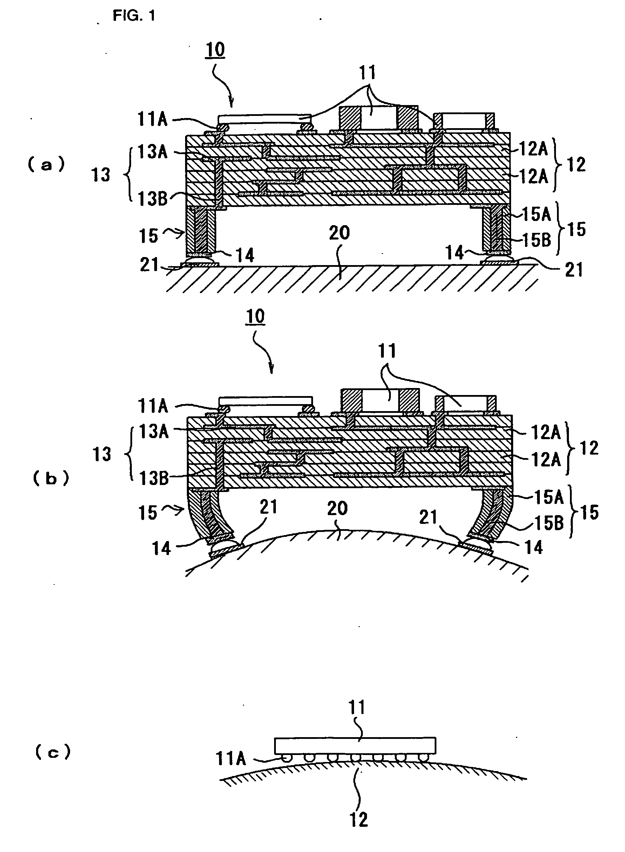

The present invention will now be described with reference to embodiments shown in Figs. 1 to 15.

### First Embodiment

A composite ceramic substrate 10 according to this embodiment, for example, as shown in (a) and (b) of Fig. 1, includes a ceramic substrate 12 mounted with surface-mounted components 11, a plurality of external terminal electrodes 14 connecting wiring patterns 13 formed in the ceramic substrate 12 and surface electrodes 21 on a motherboard 20, these external terminal electrodes 14, convex leg portions 15 formed with resin so as to support the external terminal electrodes 14 at an end face, and via-hole conductors 15B formed in the leg portions 15 and connecting the plurality of external terminal electrodes 14 and the wiring patterns 13. The surface-mounted components 11 are mounted on a first main face (hereinafter referred to as "the top face") of the ceramic substrate 12, and the external terminal electrodes 14 are disposed at a second main face (hereinafter referred to as "the bottom face") side of the ceramic substrate 12.

Examples of the surface-mounted components 11 to be mounted include passive components such as capacitors, inductors, and resistors and active devices such as semiconductor elements and gallium arsenide semiconductor elements. These surface-mounted components 11 are mounted on the top face of the ceramic substrate 12 by connecting with solder or electrically conductive resin 11A or by wiring with gold, aluminum, or copper wire.

The ceramic substrate 12 may be formed by sintering one ceramic green sheet or may be a multilayer ceramic substrate formed by sintering a laminate of a plurality of ceramic green sheets. Therefore, the multilayer ceramic substrate will be also described with reference number "12". When the ceramic substrate 12 is the multilayer ceramic substrate as shown in Fig. 1, the multilayer ceramic substrate 12 is formed by laminating a plurality of ceramic layers 12A as shown in (a) and (b) of Fig. 1.

The ceramic substrate 12 is preferably formed by sintering a low temperature co-fired ceramic (LTCC) material. The low temperature co-fired ceramic material is a ceramic material which can be sintered at a temperature of 1050°C or lower and can be co-sintered with a material having a low specific resistance such as silver or copper. Examples of the low temperature co-fired ceramic material include glass composite LTCC materials which are a mixture of a borosilicate glass and a ceramic powder of alumina, forsterite, or the like; crystallized glass LTCC materials of ZnO-MgO-Al₂O₃-SiO₂ crystallized glasses; and glass-free LTCC materials of BaO-Al₂O₃-SiO₂ ceramic powder, Al₂O₃-CaO-SiO₂-MgO-B₂O₃ ceramic powder, or the like. The wiring patterns 12 can be formed with metal having a low specific resistance and a low melting point such as silver or copper by forming the ceramic substrate 13 with the low temperature co-fired ceramic material. Therefore, the ceramic substrate 12 and the wiring patterns 13 can be co-sintered at a low temperature of 1050°C or lower.

When the ceramic substrate 12 is the multilayer ceramic substrate 12 as shown in (a) and (b) of Fig. 1, the wiring patterns 13 disposed in the multilayer ceramic substrate 12 are composed of in-plane conductors 13A formed along the faces of the ceramic layers 12A and via-hole conductors 13B connecting the upper and lower in-plane conductors 13A as shown in (a) of Fig. 1. The in-plane conductors 13A, of the wiring patterns 13, disposed on both top and bottom faces of the multilayer ceramic substrate 12 are formed as surface electrodes 13A. The wiring patterns 13 preferably include electrically conductive metal, such as silver or copper, as the main component, and the in-plane conductors 13A and the via-hole conductors 13B may be made of the same metal material or may be made of different metal material.

With reference to (a) and (b) of Fig. 1, the external terminal electrodes 14 are disposed on protruding ends (bonding plane of the motherboard 20 and the surface electrodes 21) of the leg portions 15 which are formed so as to protrude from the bottom face of the multilayer ceramic substrate 12. The leg portions 15 each include a resin portion 15A and the via-hole conductor 15B passing through the resin portion 15A, and are formed, for example, at a plurality positions of the periphery of the multilayer ceramic substrate 12. The via-hole conductors 15B electrically connect the surface electrodes (in-plane conductors) 13A disposed on the bottom face of the multilayer ceramic substrate 12 and the external terminal electrodes 14. The external terminal electrodes 14 for connecting the wiring patterns 13 of the multilayer ceramic substrate 12 and the surface electrodes 21 of the motherboard 20 may be made of metal foil as described below. Alternatively, the end faces of the via-hole conductors 15B in the leg portions 15 can be directly used as the external terminal electrodes. Additionally, the via-hole conductors 15B may be directly connected to the via-hole conductors 13B of the multilayer ceramic substrate 12.

The external terminal electrodes 14 are preferably made of metal foil such as copper. The external terminal electrodes 14 having a low resistance can be formed at low cost by forming the external terminal electrodes 14 with the metal foil. Additionally, the external terminal electrodes 14 can be bonded to the leg portions 15 more tightly by roughening the resin-side surface of the external terminal electrodes 14. The external terminal electrodes 14 cannot be sintered because they are disposed at the resin layer side, i.e., in the leg portions 15 made of composite resin, and a combination of copper foil and resin can be prepared by a method for manufacturing printed wiring board. With these reasons, the external terminal electrodes 14 are made of metal foil such as copper foil instead of thick film electrodes.

The resin portions 15A of the leg portions 15 are preferably made of, but not limited to, a composite resin material which is a mixture of a resin material and an inorganic filler. Examples of the resin material include, but not limited to, a thermosetting resin and photosetting resin. Preferably, the thermosetting resin such as an epoxy resin, a phenolic resin, and a cyanate resin is used. With respect to the inorganic filler, since metal powder has electrical conductivity and may harm the insulation of the resin portions, materials having electrical insulation, for example, Al₂O₃, SiO₂, and TiO₂, are preferably used, but not limited to these.

The via-hole conductors 15B of the leg portions 15 preferably have flexibility so as to be bent corresponding to the bending of the resin portions 15A, and are preferably made with, for example, solder or electrically conductive resin. Examples of the electrically conductive resin include, but not limited to, mixtures of metal particles of gold, silver, copper, nickel, or the like and a thermosetting resin such as an epoxy resin, a phenolic resin, and a cyanate resin. The thickness (height) of the leg portions 15 depends on the area of the multilayer ceramic substrate 12 and the type of the resin material, but is preferably 30 to 500 µm, more preferably 30 to 300 µm so that the bending of the motherboard 20 will not influence the multilayer ceramic substrate 12 and that the strength of the leg portions 15 themselves can be maintained.

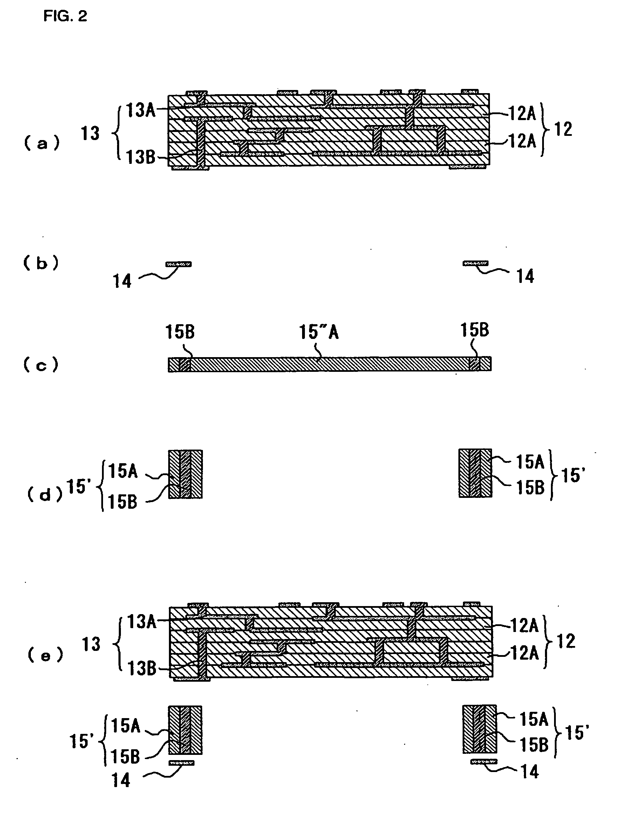

The composite ceramic substrate of this embodiment can be manufactured as described below. The manufacturing processes of the composite ceramic substrate are schematically shown in (a) to (e) of Fig. 2.

### (1) Preparation of ceramic green sheet

In this embodiment, first, for example, 55 w/t parts of alumina particles having a mean particle size of 1.0 µm and 45 w/t parts of borosilicate glass having a mean particle size of 1.0 µm and a softening point of 600°C are mixed, and then, to the resulting mixture, an organic solvent, a dispersant, an organic binder, and a plasticizer are added to prepare a slurry. Then, the slurry is applied to a carrier film of a polyethylene terephthalate resin to prepare a ceramic green sheet of a low temperature co-fired ceramic material having a thickness about 10 to 200 µm.

Then, via-holes having a diameter of about 0.1 mm are formed in the ceramic green sheet by laser machining or punching, and then the ceramic green sheet is adhered on a flat and smooth supporting table. An electrically conductive paste is prepared by kneading metal powder predominantly composed of silver powder or copper powder, a thermosetting resin, and an organic solvent. The electrically conductive paste is compressed into openings for via-hole conductors of the ceramic green sheet adhered on the supporting table from the carrier film side with a squeegee while scraping the excess electrically conductive paste. Thus, via-hole layers for via-hole conductors are formed. In this case, the via-holes can be certainly filled with the electrode paste by reducing the pressure in the via-holes using an aspirating mechanism set on the supporting table. Predetermined patterns of electrically conductive paste are printed on the respective ceramic green sheets by screen printing. After drying, printed paste layers and conductive paste layers to be in-plane conductors and via-hole conductors are formed as wiring pattern layers.

### (2) Preparation of ceramic multilayer board

The ceramic green sheets, on which the wiring pattern layers are formed, are laminated in predetermined order to prepare a laminate and then are press-bonded at a pressure of 0.1 to 1.5 MPa at a temperature of 40 to 100°C to prepare a green laminate. After the removing of the binder from the green laminate, the laminate is sintered in air at about 850°C when the wiring pattern layer is a silver base and is sintered in a nitrogen atmosphere at about 950°C when the wiring pattern layer is a copper base. Thus, a multilayer ceramic substrate 12 shown in (a) of Fig. 2 is prepared. Then, films of Ni/Sn, Ni/Au, or the like are formed on the upper and lower electrodes by wet plating, if necessary.

### (3) Preparation of external terminal electrode

The external terminal electrodes 14 to be mounted can be prepared by processing copper foil by a known etching method. Namely, copper foil having a thickness of about 10 to 40 µm is adhered to a carrier film, and patterning of the copper foil by photoresist coating, exposure, development, etching, and removing of the resist film is performed. Thus, the external terminal electrodes 14 shown in (b) of Fig. 2 are prepared.

### (4) Preparation of resin sheet for leg portion

A resin sheet for the leg portions 15 is prepared. Namely, a composite resin material mixture of a thermosetting resin such as an epoxy resin, a phenolic resin, and a cyanate resin and an inorganic filler such as Al₂O₃, SiO₂, and TiO₂ is formed into a sheet on a carrier film by doctor blade method to prepare a resin sheet 15"A of semi-cured state (B-stage) shown in (c) of Fig. 2. In this case, the cross-linking reaction of the epoxy thermosetting resin is enhanced by thermally treating these materials and the viscosity is adjusted such that the epoxy thermosetting resin on the carrier film will not flow. Optimum time for the thermal treatment depends on characteristics of the thermosetting resin.

### (5) Preparation of leg portion

Via-holes are formed in predetermined portions of the resin sheet 15"A by using laser beams, and then, as shown in (c) of Fig. 2, the via-holes are filled with the via-hole conductors 15B of solder or electrically conductive resin. After the preparation of a predetermined number of the resin sheets 15"A, each of the resin sheets 15"A is processed into a desired shape (the shape of the leg portion) by laser machining or punching (see (d) in Fig. 2). Then, leg portions 15 having a desired film thickness are prepared by stacking a desired number of the resin sheets 15"A. In this case, the laser machining or punching may be performed after the stacking of the desired number of the resin sheet 15"A. When the solder is used as the via-hole conductors 15B, a reflow process is performed for bonding the solder to the in-plane conductors 12A on the bottom face of the multilayer ceramic substrate 12 and to the external terminal electrodes 14. In other words, the reflow process may be performed after the lamination of the leg portions 15 to the multilayer ceramic substrate 12, or the reflow process may be performed after the mounting of surface-mounted components so that etching and bonding can be simultaneously performed during the reflow process after the mounting of the surface-mounted components.

### (6) Preparation of composite ceramic substrate

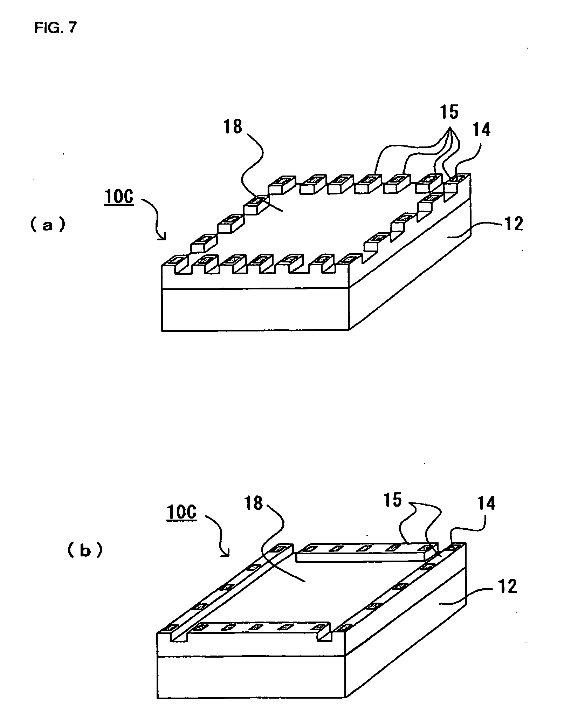

As shown in (e) of Fig. 2, the external terminal electrodes 14, the leg portions 15, and multilayer ceramic substrate 12 are positioned in this order from the bottom to the top, and then lamination process of laminating, heating, and pressurizing is performed. Specifically, the composite ceramic substrate 10 shown in (a) of Fig. 1 is manufactured by adhering the leg portions 15 to the bottom face of the multilayer ceramic substrate 12 and further adhering the external terminal electrodes 14 to the bottom faces of the leg portions 15. In this case, the multilayer ceramic substrate 12, the leg portions 15, and the external terminal electrodes 14 are press-bonded by cold isostatic pressing so that the leg portions 15 are certainly bonded to the multilayer ceramic substrate 12 while maintaining the shape of the leg portions 15. Main curing of the leg portions 15 and the resin portions 15A can be performed by heating the united composite ceramic substrate 12 and the leg portions 15, for example, at 170°C for one hour. Then, the surface-mounted components 11 are mounted on the top face of the multilayer ceramic substrate 12 by using solder or conductive resin; thus, the composite ceramic substrate 10 of this embodiment can be manufactured as a module component. The external terminal electrodes 14 of the composite ceramic substrate 10 are constituted to have a land grid array (LGA) structure (see Fig. 7) which does not have solder filler when they are mounted.

For example, a thickness of the leg portions 15, i.e., a protrusion size from the multilayer ceramic substrate 12, satisfactory for fulfilling its function is 50 µm when the multilayer ceramic substrate 12 is 10 square mm. The protrusion size of the leg portions 15 must be changed according to a change in the size of the multilayer ceramic substrate 12. When the size of the multilayer ceramic substrate 12 is small, the protrusion size may be small. Inversely, when the size of the multilayer ceramic substrate 12 is large, the protrusion size may be large. The leg portions 15 are preferably formed along the periphery of the bottom face of the multilayer ceramic substrate 12. The forming of the leg portions 15 along the periphery of the bottom face of the multilayer ceramic substrate 12 stabilizes the mounting to the motherboard 20, which improves the reliability.

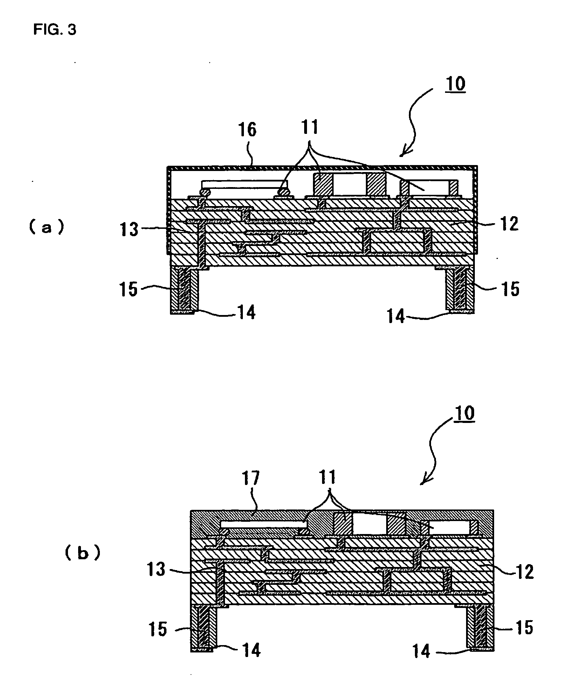

When the composite ceramic substrate 10 of this embodiment is mounted on the motherboard 20 with a mounter, as shown in (a) of Fig. 3, it is preferable that the surface-mounted components 11 on the top face of the composite ceramic substrate 10 are previously covered with a case 16 so that the composite ceramic substrate 10 can be readily handled with the mounter. Examples of the case 16 include, but not limited to, metal materials such as white metal and phosphor bronze.

In order to achieve a similar purpose, as shown in (b) of Fig. 3, the entire top face of the composite ceramic substrate 10 may be coated with a composite resin material containing a thermosetting resin as a main component so that a resin layer 17 coats the surface-mounted components 11. In this instance, it is preferable that the thermal expansion coefficient of the resin layer 17 to be used is substantially the same as that of the resin portions 15A forming the leg portions 15. With this, warpage and cracking of the composite ceramic substrate 10 itself during the thermal treatment such as a reflow process can be avoided. Therefore, as mentioned above, the resin layer 17 is preferably formed by the same composite resin material as that forming the resin portions 15A of the leg portions 15, instead of the thermosetting resin alone. The forming of the resin portions 15A of the leg portions 15 and the resin layer 17 by the same composite resin material can certainly prevent the warpage and cracking of the composite ceramic substrate 10 itself.

As shown in (a) of Fig. 1, the composite ceramic substrate 10 is mounted on the motherboard 20 such as a printed wiring board as a module component by using the mounter. The composite ceramic substrate 10 is electrically connected to the surface electrodes 21 of the motherboard 20 via the external terminal electrodes 14. Since the leg portions 15 have flexibility, even if the motherboard 20 is bent as exaggeratingly shown in (b) of Fig. 1, the leg portions 15 bend itself corresponding to the bending of the motherboard 20 as shown by the drawing to prevent the multilayer ceramic substrate 12 from being deformed. Therefore, unlike the conventional way, the multilayer ceramic substrate 12 is not damaged. Furthermore, breaking wire or detachment caused by partial disconnection of the surface-mounted components 11 from the multilayer ceramic substrate 12 shown in (c) of Fig. 1 may not occur.

As described above, according to this embodiment, the composite ceramic substrate 10 includes the multilayer ceramic substrate 12 mounted with the surface-mounted components 11, the external terminal electrodes 14 connecting the wiring patterns 13 in the multilayer ceramic substrate 12 and the surface electrodes 21 on the motherboard 20, the convex leg portions 15 formed with a composite resin material so as to support the external terminal electrodes 14 at an end face, and via-hole conductors 15B formed in the leg portions 15 and connecting the external terminal electrodes 14 and the wiring patterns 13. Therefore, when the motherboard 20 is bent as shown in (b) of Fig. 1, the leg portions 15 can bend corresponding to the bending of the motherboard 20 to prevent the multilayer ceramic substrate 12 itself from being bent. With this, breaking of wire caused by disconnection of the composite ceramic substrate 10 itself from the motherboard 20, breaking of wire caused by disconnection of the surface-mounted components 11 from the multilayer ceramic substrate 12 as shown in (c) of Fig. 1, and damage of the surface-mounted components 11 themselves are prevented. Thus, the reliability can be highly improved.

### Second Embodiment

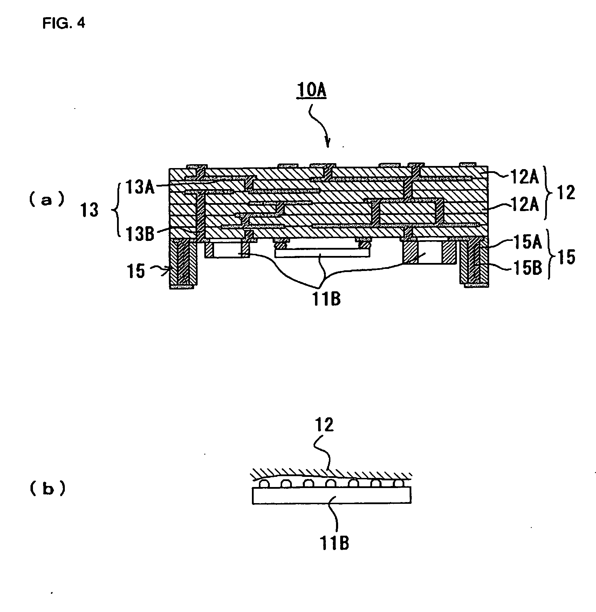

A composite ceramic substrate 10A, for example, as shown in (a) of Fig. 4, of this embodiment is constituted as the composite ceramic substrate 10 of the first embodiment except that the surface-mounted components 11B are mounted only on the bottom face of the multilayer ceramic substrate 12, which is contrary to the composite ceramic substrate 10 of the first embodiment.

In manufacturing of the composite ceramic substrate 10A of this embodiment, the multilayer ceramic substrate 12 is prepared as in the first embodiment, and then the surface-mounted components 11B are mounted on the bottom face of the multilayer ceramic substrate 12. Then, the leg portions 15 and the external terminal electrodes 14 are prepared as in the first embodiment and are attached to the multilayer ceramic substrate 12 so as to be positioned at the outer side of the surface-mounted components 11. Thus, the composite ceramic substrate 10A can be manufactured.

In this embodiment, the surface-mounted components 11B are mounted on the bottom surface of the multilayer ceramic substrate 12 as in the leg portions 15, so the leg portions 15 are formed so as to protrude downward further than a surface-mounted component 11B having the largest protrusion size (thickness).

Therefore, in this embodiment, since the space between the leg portions 15 of the multilayer ceramic substrate 12 is effectively used for mounting the surface-mounted components 11B, the composite ceramic substrate 10A can be decreased in size and height while achieving the same functions and advantageous effects as those in the first embodiment. The leg portions 15 can bend corresponding to the bending of the motherboard 20 to prevent the multilayer ceramic substrate 12 from being bent even if the motherboard 20 is bent. With this, breaking of wire caused by disconnection, shown in (b) of Fig. 4, of the surface-mounted components 11B from the multilayer ceramic substrate 12 and damage of the surface-mounted components 11B themselves are prevented. Thus, the reliability can be highly improved.

### Third Embodiment

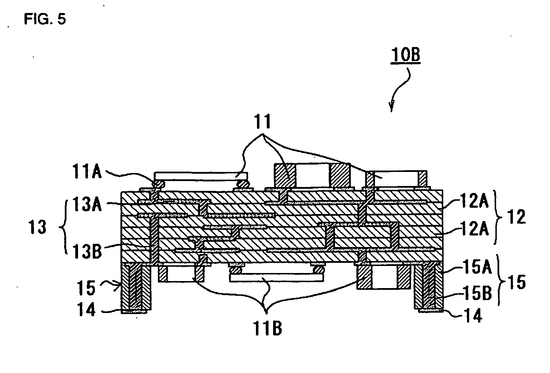

A composite ceramic substrate 10B, for example, as shown in Fig. 5, of this embodiment is constituted as the composite ceramic substrate 10A of the second embodiment except that the surface-mounted components 11 are mounted on the top face in addition to the bottom face of the multilayer ceramic substrate 12.

In manufacturing of the composite ceramic substrate 10B of this embodiment, the surface-mounted components 11B are mounted on the bottom face of the multilayer ceramic substrate 12 as in the second embodiment, and then the leg portions 15 and the external terminal electrodes 14 are prepared as in the first and second embodiments and are attached to the multilayer ceramic substrate 12 so as to be positioned at the outer side of the surface-mounted components 11B. Then, the surface-mounted components 11 are mounted on the top face of the multilayer ceramic substrate 12 as in the first embodiment. Thus, the composite ceramic substrate 10B can be manufactured. In this case, the surface-mounted components 11 and 11A on the top and bottom faces of the multilayer ceramic substrate 12 can be suitably selected according to required functions and be mounted.

Therefore, in this embodiment, since the surface-mounted components 11 are mounted on the top face of the multilayer ceramic substrate 12 and the space between the leg portions 15 of the multilayer ceramic substrate 12 is effectively used for mounting the surface-mounted components 11B, the same functions and advantageous effects as those in the first and second embodiments can be achieved and, additionally, advanced capabilities through further high-density mounting can be realized.

### Fourth Embodiment

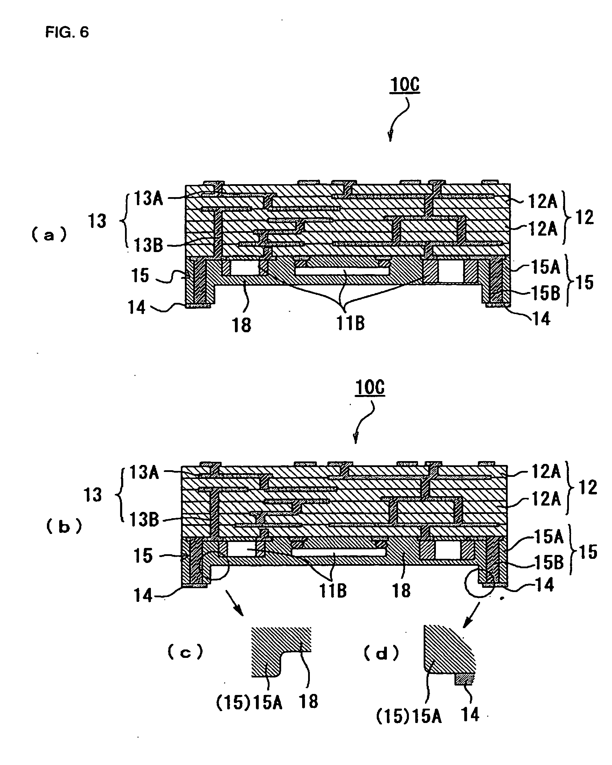

A composite ceramic substrate 10C, for example, as shown in (a) and (b) of Fig. 6, of this embodiment is constituted as the composite ceramic substrate 10A of the second embodiment except that the surface-mounted components 11B mounted on the bottom face of the multilayer ceramic substrate 12 of the second embodiment are coated with a composite resin layer 18.

In manufacturing of the composite ceramic substrate 10C of this embodiment, the surface-mounted components 11B are mounted on the bottom face of the multilayer ceramic substrate 12 as in the second embodiment, and then the composite resin layer 18, the leg portions 15, and the external terminal electrodes 14 are attached to the multilayer ceramic substrate 12. These three components 14, 15, and 18 can be attached by, for example, the following two methods:
In a first method, after the lamination of the composite resin layer 18, the leg portions 15 are laminated. More specifically, resin sheets having the via-hole conductors 15B are prepared as in the first embodiment. A plurality of resin sheets is stacked so as to have a thickness sufficient for embedding the surface-mounted components 11B. Then, after the stacking of the resin sheets, these laminated resin sheets and the multilayer ceramic substrate 12 are positioned so that the laminated resin sheets are laminated on the multilayer ceramic substrate 12 to embed the surface-mounted components 11B. Thus, the composite resin layer 18 is formed. Then, the external terminal electrodes 14 and the leg portions 15, which are prepared as in the first embodiment, are positioned to the multilayer ceramic substrate 12 so as to be laminated to the composite resin layer 18 of the multilayer ceramic substrate 12 as in the first embodiment. The leg portions 15 are press-bonded to the periphery of the composite resin layer 18 by cold isostatic pressing, and then main curing of the composite resin layer 18 and the resin portions 15A of the leg portions 15 are performed. Thus, the composite ceramic substrate 10C is manufactured.
In a second method, the composite resin layer 18 and the leg portions 15 are simultaneously formed. More specifically, copper foil to be the external terminal electrodes 14 and the laminated resin sheets are positioned in respect to the multilayer ceramic substrate 12, and then both components are laminated to the bottom face of the multilayer ceramic substrate 12 so that the surface-mounted components 11B are embedded in the laminated resin sheets. Thus, the resin layer is formed. Then, the resin layer is pressed from the bottom face by using a metal mold having a convex shape so that the composite resin layer 18 is formed into a concave shape and, simultaneously, the leg portions 15 are formed into a convex shape. Then, main curing of the composite resin layer 18 and the resin portions 15A of the leg portions 15 are performed. Thus, the composite ceramic substrate 10C is manufactured.

In this embodiment, a composite resin material for constituting each of the leg portions 15 and the composite resin layer 18 is maintained at a good fluidity state when the leg portions 15 and the composite resin layer 18 are formed. A smooth round portion is formed at a portion (c) shown by a circle in (b) of Fig. 6, i.e., at the boundary of the composite resin layer 18 and the leg portion 15, when the composite resin material cures. Additionally, smooth round portions are also formed at a portion (d) shown by a circle in (b) of Fig. 6, i.e., at the edge of the leg portion 15, and at other edges when the composite resin material cures.

The leg portions 15 in this embodiment are formed at the periphery of the composite resin layer 18, for example, as shown in (a) and (b) of Fig. 7. The leg portions 15 shown in (a) of Fig. 7 are arranged at predetermined intervals along the entire periphery of the composite resin layer 18, and each bottom face of the leg portions 15 supports the respective external terminal electrodes 14. The leg portions 15 shown in (b) of Fig. 7 have first parts formed in an elongated shape along the entire length of two edges opposing to each other of the composite resin layer 18 and second parts formed along the remaining two edges so as to have gaps from both ends of the first parts. The first and second parts support the external terminal electrodes 14 arranged at predetermined intervals.

Therefore, according to this embodiment, the surface-mounted components 11B mounted on the bottom face of the multilayer ceramic substrate 12 are protected by the composite resin layer 18. Simultaneously, the leg portions 15 are protrudently formed at the periphery of the composite resin layer 18. Therefore, detachment of the surface-mounted components 11B from the multilayer ceramic substrate 12 can be more certainly avoided. Additionally, influences by the bending of the motherboard can be absorbed by the leg portions 15 and disconnection of the surface-mounted components 11B can be more certainly avoided, compared to a case when the composite ceramic substrate is merely mounted on the motherboard via the composite resin layer. Thus, reliability can be improved.

According to this embodiment, since the boundaries of the composite resin layer 18 and the leg portions 15 have a smooth round portion (see (c) of Fig. 6), stress concentration to the boundaries can be prevented. Consequently, occurrence of cracking or the like can be prevented to improve the reliability. Since the corners (see (d) of Fig. 6) of the leg portions 15 and other corners also have a smooth round portion, occurrence of chipping or the like can be prevented to improve the reliability.

Furthermore, according to this embodiment, since the leg portions 15 are formed at the periphery of the composite resin layer 18, even if the surface-mounted components 11B embedded in the composite resin layer 18 are partially bared, the bared parts hardly come into contact with the exterior during the composite ceramic substrate is mounted on the motherboard or is handled. Consequently, breakage of the surface-mounted components 11B can be prevented to improve the reliability.

### Fifth Embodiment

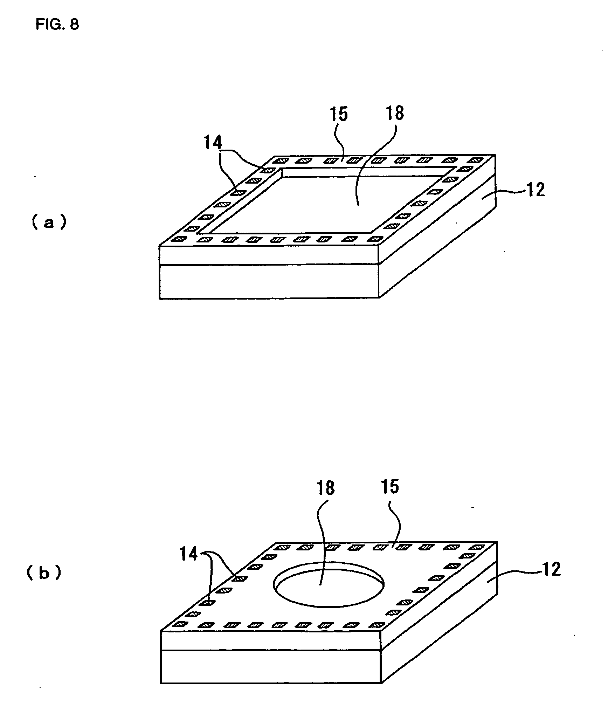

In this embodiment, as shown in (a) and (b) of Fig. 8, since the composite ceramic substrate is constituted as that of the fourth embodiment except that shapes of the leg portions 15 are different, only characteristic parts of this embodiment will be described with the same reference numbers as those in the fourth embodiment for the same or equivalent parts. In this embodiment, the leg portion 15 shown in (a) of Fig. 8 is formed by integrally projecting the entire periphery of the composite resin layer 18 in a rectangular frame shape, and the leg portion 15 supports a plurality of external terminal electrodes 14 arranged at predetermined intervals on the entire circumference of its bottom face. Therefore, in the inside of the leg portion 15 of the rectangular frame shape, a rectangular recess is formed as the bottom face of the composite resin layer 18. This rectangular recess may be formed, for example, as shown in (b) of Fig. 8, as a circular recess. These leg portions 15 can be formed by the same process in the fourth embodiment. This embodiment can achieve the same functions and advantageous effects as in the fourth embodiment.

The rectangular frame-shaped leg portion 15 shown in (a) of Fig. 8 can be applied to the composite ceramic substrates shown in Fig. 1, Fig. 3, (a) and (b) of Fig. 4, and Fig. 5. In such cases, the composite resin layer 18 is not formed in the inside of the leg portion 15, and the bottom face of the multilayer ceramic substrate 12 and the surface-mounted components 11B are bared.

### Sixth Embodiment

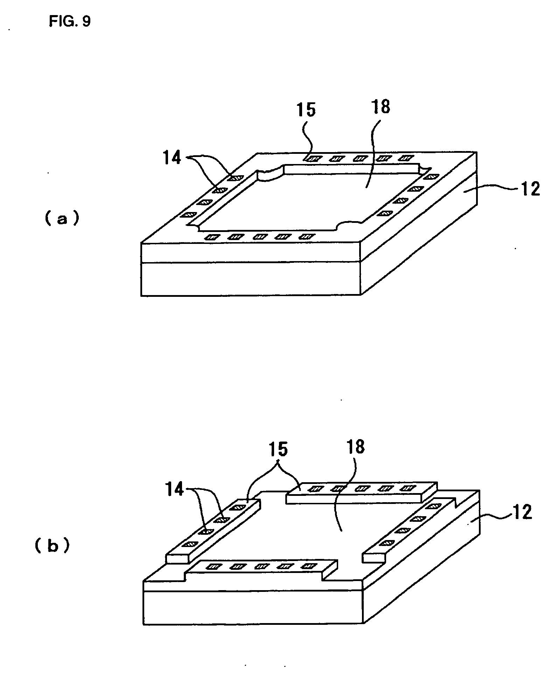

In this embodiment, as shown in (a) and (b) of Fig. 9, since the composite ceramic substrate is constituted as that of the fifth embodiment except that a shape of the leg portion 15 and arrangement of the external terminal electrodes 14 are different, only characteristic parts of this embodiment will be described with the same reference numbers as those in the fifth embodiment for the same or equivalent parts. The leg portion 15 shown in (a) of Fig. 9 is formed to be substantially the same as that shown in (a) of Fig. 8. The leg portion 15 supports a plurality of external terminal electrodes 14 at the portions other than the corners. Therefore, the external terminal electrodes 14 are not disposed at the corners. By adopting such a structure, impact resistance of the composite ceramic substrate mounted on a mount board such as a motherboard can be improved.

In other words, if the mount board on which the composite ceramic substrate is mounted receives an impact caused by a fall or the like, the impact causes complicated flexure in the mount board and the stress caused by the flexure is transmitted to the leg portion 15 via the external terminal electrodes 14. At the leg portion 15, the stress transmitted by each of the external terminal electrodes 14 tends to be concentrated at each corner (point where straight lines intersect with each other, each of the straight lines running through the centers of the external terminal electrodes 14 arranged in lines being orthogonal to each other) via the leg portion 15. However, in this embodiment, since the external terminal electrodes 14 are not disposed at the corners, there are no external terminal electrodes 14 receives the concentrated stress at the corners. Consequently, disconnection of the external terminal electrodes 14 does not occur at the corners; which can improve impact resistance. The concentrated stress mainly influences the flat corners of the leg portion 15 where the external terminal electrodes 14 are disposed. Therefore, as shown in (b) of Fig. 9, the concentration of the stress at the corners can be prevented by lowering the corners toward the direction of the composite resin layer 18 so that the height position of the corners is lower than the bottom face of the leg portion 15 where the external terminal electrodes 14 are disposed. Thus, the impact resistance can be further improved.

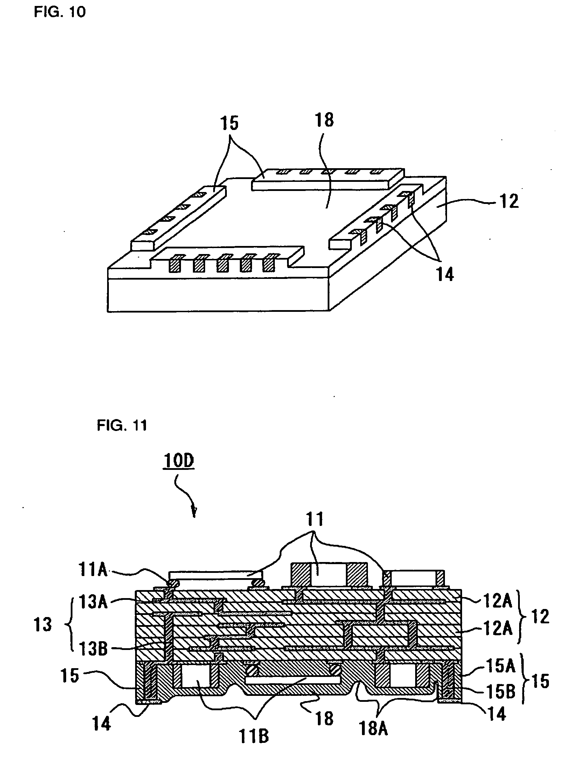

Even if the external terminal electrodes 14 are not disposed at the corners of the rectangular frame-shaped leg portion 15, or the height position of the corners is lowered, the external terminal electrodes 14 receive impactive force as long as the composite ceramic substrate is mounted on the mount board. Then, as show in Fig. 10, the bonding strength with the mount board is strengthened by elongating the external terminal electrodes 14 from the bottom face to the outside face of the leg portion 15 and not only bonding the bottom faces of the external terminal electrodes 14 but also forming fillets such as solder on the side faces of the external terminal electrodes 14. Thus, the impact resistance can be improved.

### Seventh Embodiment

In a composite ceramic substrate 10D of this embodiment, for example, as shown in Fig. 11, the surface-mounted components 11B are mounted on the bottom face of the multilayer ceramic substrate 12 of the third embodiment and the composite resin layer 18 formed as in the fourth embodiment has slits 18A. The slits 18A are roundly formed so as to partition the plurality of surface-mounted components 11B into individual each device. The slits 18A can be formed, for example, by cold isostatic pressing when the composite resin layer 18 and the leg portions 15 in the fourth embodiment are formed by press-forming. With this, the slits 18A can be formed into shapes tracing the concaves and convexes of the surface-mounted components 11B, to some degree.

Therefore, according to this embodiment, by forming the slits 18A corresponding to the shapes of the respective surface-mounted components 11B, the composite resin layer 18 having a thickness larger than a certain value can be formed at the outside of the surface-mounted components 11B. As a result, the surface-mounted components 11B can be prevented from protruding from the composite resin layer 18. Thus, the surface-mounted components 11B can be further certainly protected.

### Eighth Embodiment

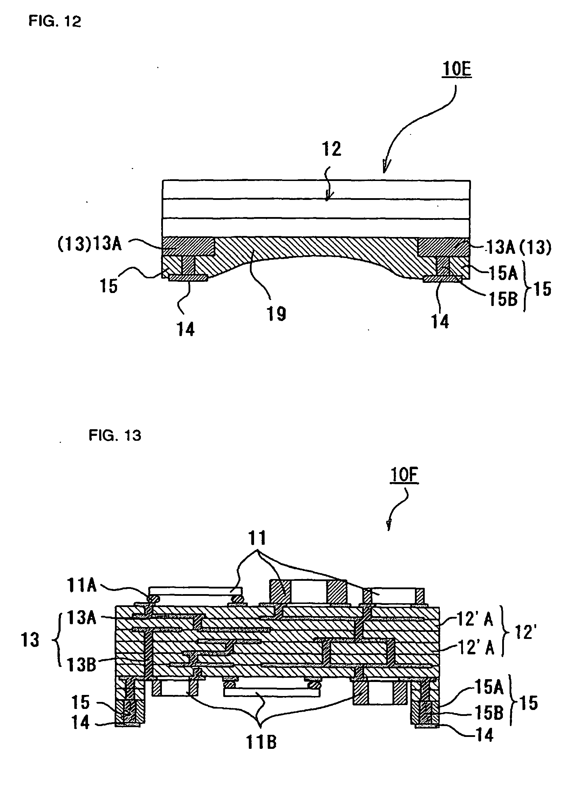

In a composite ceramic substrate 10E of this embodiment, for example, as shown in Fig. 12, a composite resin layer 19 has a thickness increasing progressively from the central portion of the composite resin layer 19 toward the plurality of external terminal electrodes 14 to form a plurality of leg portions 15 at the periphery. In other words, the surface electrodes 13A disposed on the bottom face of the multilayer ceramic substrate 12 can have a thickness larger than that of the in-plane conductors disposed in the inside of the multilayer ceramic substrate 12. Thus, a recess smoothly curving toward the central portion of the composite resin layer 19 is formed. That is, in this embodiment, the surface-mounted components are not built in the composite resin layer 19, but they may be built in the composite resin layer 19. In Fig. 12, wiring patterns of the multilayer ceramic substrate 12 are omitted.

Therefore, according to this embodiment, the same functions and advantageous effects as the first embodiment can be achieved. More specifically, the composite resin layer 19 recessing gradually from the periphery toward the central portion is not flat, consequently, even if the motherboard is bent to become into contact with the composite ceramic substrate 10E, the contacting occurs at a plurality of points to disperse the force. Thus, cracking at the contacting points can be prevented.

### Ninth Embodiment

A composite ceramic substrate 10F of this embodiment is, for example, as shown in Fig. 13, constituted as the first embodiment except that the multilayer ceramic substrate 12' has a cavity C. The cavity C is formed, for example, by preparing a required number of ceramic green sheets (two sheets in the drawing) having a through-hole for the cavity C when the multilayer ceramic substrate 12' is prepared. Then, the ceramic green sheets having the through-hole are provided with via-hole conductors and in-plane conductors and are laminated to the other ceramic green sheets not having the through-hole. Thus, a ceramic green laminate is prepared. The multilayer ceramic substrate 12' having a cavity can be prepared by sintering this ceramic green laminate. Then, the leg portions 15 are attached as in the first embodiment. According to this embodiment, the height of the composite ceramic substrate can be further decreased by mounting the surface-mounted components 11B in the cavity C.

### Tenth Embodiment

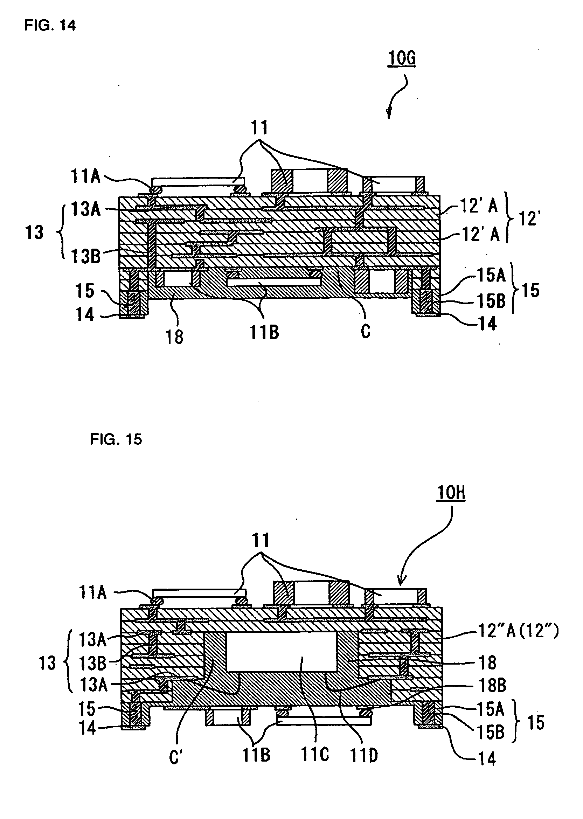

A composite ceramic substrate 10G of this embodiment is, for example, as shown in Fig. 14, constituted according to the seventh embodiment shown in Fig. 11 except that the multilayer ceramic substrate 12' has the cavity C. The cavity C can be formed as in the ninth embodiment. In this embodiment, the slits 18A shown in Fig. 11 are not formed in the bottom face of the composite resin layer 18, but the slits 18A shown in Fig. 11 may be formed in this embodiment. According to this embodiment, in comparison with the composite ceramic substrate 11D shown in Fig. 11, the composite ceramic substrate 11G can be further decreased in the height by mounting the surface-mounted components 11B in the cavity C. In this case, as shown in Fig. 14, the height of the surface-mounted components 11B disposed in the cavity C may be larger than the depth of the cavity C. In other words, though a deep cavity is difficult to form, a decrease in the height can be achieved even if the depth of the cavity is not large sufficient to completely embed the surface-mounted components 11B. Eleventh Embodiment

In a composite ceramic substrate 10H of this embodiment, for example, as shown in Fig. 15, a multilayer ceramic substrate 12" has a two-stage cavity C' and surface-mounted component 11C including an active component such as a semiconductor or the like is mounted on the base of the cavity C'. The multilayer ceramic substrate 12" having the two-stage cavity C' can be formed by preparing two types of the ceramic green sheets having the through-hole being different in the size at the central portions; laminating each of the ceramic green sheets as many pieces as required, respectively; laminating the ceramic green sheets having the through-hole to the ceramic green sheets not having the through-hole; and sintering the laminate. As shown in Fig. 15, the surface-mounted component 11C is connected to the surface electrodes 13A, of which terminal electrodes are formed on the inside stage planes, via bonding wires 11D. The composite resin layer 18 is formed in the cavity C' so as to seal the surface-mounted component 11C. The leg portions 15 are formed at the periphery of the bottom face of the composite resin layer 18, and surface electrodes 18B in a predetermined pattern are formed on the inside of the leg portions. With respect to the leg portions 15, various shapes described in the above-mentioned embodiments can be used according to requirement. The surface-mounted components 11B are mounted on the bottom face of the composite resin layer 18 and are connected to the wiring pattern 13 of the multilayer ceramic substrate 12 via the surface electrodes 18B.

Therefore, according to this embodiment, the surface-mounted component 11C is mounted on the base of the cavity C' and the other surface-mounted components 11B are mounted on the bottom face of the composite resin layer 18 sealing the surface-mounted component 11C, consequently, further high-density mounting of the surface-mounted components can be achieved. Thus, further high functional capability can be realized.

The scope of the present invention is not limited by the disclosure of the above-mentioned embodiments and is understood in the broadest sense.

### Industrial Applicability

The present invention can be suitably applied to composite ceramic substrates mounted with surface-mounted components of active components such as semiconductors and passive components such as capacitors.

## Claims

1. A composite ceramic assembly comprising:
a ceramic substrate (10) mounted with a surface-mounted component (11),
an external terminal electrode (14) connected to a wiring pattern (13) formed on the ceramic substrate (10),
**characterized by**
a convex leg portion (15) formed of resin (15A) such that an end face thereof supports the external terminal electrode (14), and
a via-hole conductor (15B) formed in the convex leg portion (15) and connecting the external terminal electrode (14) and the wiring pattern (13).

2. The composite ceramic assembly according to claim 1, wherein the surface-mounted component (11) is mounted on a first main face and/or a second main face of the ceramic substrate (10) and the convex leg portion (15) is disposed on the second main face of the ceramic substrate (10).

3. The composite ceramic assembly according to claim 2, wherein the convex leg portion (15) is disposed at the periphery of the second main face of the ceramic substrate (10).

4. The composite ceramic assembly according to claim 3, wherein a plurality of the external terminal electrodes (14) is supported by the end face of a single convex leg portion (15).

5. The composite ceramic assembly according to claim 4, wherein the external terminal electrodes (14) are not disposed at corners of the second main face of the ceramic substrate (10).

6. The composite ceramic assembly according to claim 5, wherein the corners are lower than the height where the external terminal electrodes (14) are disposed.

7. The composite ceramic assembly according to any one of claims 2 to 6, wherein the surface-mounted component (11) is mounted between the convex leg portions (15) on the second main face.

8. The composite ceramic assembly according to claim 7, wherein the surface-mounted component (11) is supported with resin (18) that is the same as that forming the convex leg portion (15).

9. The composite ceramic assembly according to claim 8, wherein a round portion is formed between the convex leg portion (15) and the resin coating (18) the surface-mounted component (11).

10. The composite ceramic assembly according to claim 8 or 9, wherein the surface of the resin coating the surface-mounted component (11) has a slit (18A).

11. The composite ceramic assembly according to any one of claims 1 to 10, wherein an edge of the convex leg portion (15) is formed into a rounded shape.

12. The composite ceramic assembly according to any one of claims 1 to 11, wherein the via-hole conductor is formed with conductive resin having flexibility.

13. The composite ceramic assembly according to any one of claims 1 to 12, wherein the ceramic substrate (10) is a multilayer ceramic substrate (10) formed by laminating a plurality of low temperature co-fired ceramic layers.

14. The composite ceramic assembly according to any one of claims 1 to 13, wherein the surface-mounted component (11) has external terminal electrodes (14) in an array.

## Patentansprüche

1. Eine Zusammensetzungskeramikanordnung, die folgende Merkmale aufweist:
ein Keramiksubstrat (10), das mit einer oberflächenbefestigten Komponente (11) befestigt ist,
eine externe Abschlusselektrode (14), die mit einer Verdrahtungsstruktur (13) verbunden ist, die an dem keramischen Substrat (10) gebildet ist,
**gekennzeichnet durch**
einen Konvexbeinabschnitt (15), der aus einem Harz (15A) gebildet ist, derart, dass eine Endseite desselben die externe Abschlusselektrode (14) stützt, und
einen Durchkontaktierungslochverbinder (15B), der in dem Konvexbeinabschnitt (15) gebildet ist und die externe Abschlusselektrode (14) und die Verdrahtungsstruktur (13) verbindet.

2. Die Zusammensetzungskeramikanordnung gemäß Anspruch 1, bei der die oberflächenbefestigte Komponente (11) an einer ersten Hauptseite und/oder einer zweiten Hauptseite des Keramiksubstrats (10) befestigt ist und der Konvexbeinabschnitt (15) an der zweiten Hauptseite des Keramiksubstrats (10) angeordnet ist.

3. Die Zusammensetzungskeramikanordnung gemäß Anspruch 2, bei der der Konvexbeinabschnitt (15) an der Peripherie der zweiten Hauptseite des Keramiksubstrats (10) angeordnet ist.

4. Die Zusammensetzungskeramikanordnung gemäß Anspruch 3, bei der eine Mehrzahl der externen Abschlusselektroden (14) durch die Endseite eines einzigen Konvexbeinabschnitts (15) gestützt ist.

5. Die Zusammensetzungskeramikanordnung gemäß Anspruch 4, bei der die externen Abschlusselektroden (14) nicht an Ecken der zweiten Hauptseite des keramischen Substrats (10) angeordnet sind.

6. Die Zusammensetzungskeramikanordnung gemäß Anspruch 5, bei der die Ecken niedriger als die Höhe sind, wo die externen Abschlusselektroden (14) angeordnet sind.

7. Die Zusammensetzungskeramikanordnung gemäß einem der Ansprüche 2 bis 6, bei der die oberflächenbefestigte Komponente (11) zwischen den Konvexbeinabschnitten (15) an der zweiten Hauptseite befestigt ist.

8. Die Zusammensetzungskeramikanordnung gemäß Anspruch 7, bei der die oberflächenbefestigte Komponente (11) mit Harz (18) gestützt ist, das das gleiche ist wie dasjenige, das den Konvexbeinabschnitt (15) bildet.

9. Die Zusammensetzungskeramikanordnung gemäß Anspruch 8, bei der ein runder Abschnitt zwischen dem Konvexbeinabschnitt (15) und dem Harz, das die oberflächenbefestigte Komponente (11) beschichtet (18), gebildet ist.

10. Die Zusammensetzungskeramikanordnung gemäß Anspruch 8 oder 9, bei der die Oberfläche des Harzes, das die oberflächenbefestigte Komponente (11) beschichtet, einen Schlitz (18A) aufweist.

11. Die Zusammensetzungskeramikanordnung gemäß einem der Ansprüche 1 bis 10, bei der eine Kante des Konvexbeinabschnitts (15) in einer gerundeten Gestalt gebildet ist.

12. Die Zusammensetzungskeramikanordnung gemäß einem der Ansprüche 1 bis 11, bei der der Durchkontaktierungslochverbinder mit einem leitfähigen Harz gebildet ist, das eine Flexibilität aufweist.

13. Die Zusammensetzungskeramikanordnung gemäß einem der Ansprüche 1 bis 12, bei der das Keramiksubstrat (10) ein Mehrschichtkeramiksubstrat (10) ist, das durch ein Laminieren einer Mehrzahl von Niedertemperatur-Gleichzeitigeinbrand-Keramikschichten gebildet ist.

14. Die Zusammensetzungskeramikanordnung gemäß einem der Ansprüche 1 bis 13, bei der die oberflächenbefestigte Komponente (11) externe Abschlusselektroden (14) in einem Array aufweist.

## Revendications

1. Ensemble en céramique composite comprenant :
un substrat en céramique (10) monté avec un composant monté en surface (11),
une électrode terminale externe (14) raccordée à un motif de câblage (13) formé sur le substrat en céramique (10),
**caractérisé par**
une partie de patte convexe (15) formée de résine (15A) de sorte qu'une face d'extrémité de celle-ci soutienne l'électrode terminale externe (14), et
un conducteur de trou d'interconnexion (15B) formé dans la partie de patte convexe (15) et raccordant l'électrode terminale externe (14) et le motif de câblage (13).

2. Ensemble en céramique composite selon la revendication 1, dans lequel le composant monté en surface (11) est monté sur une première face principale et/ou une seconde face principale du substrat en céramique (10) et la partie de patte convexe (15) est disposée sur la seconde face principale du substrat en céramique (10).

3. Ensemble en céramique composite selon la revendication 2, dans lequel la partie de patte convexe (15) est disposée à la périphérie de la seconde face principale du substrat en céramique (10).

4. Ensemble en céramique composite selon la revendication 3, dans lequel une pluralité des électrodes terminales externes (14) est soutenue par la face d'extrémité d'une partie de patte convexe unique (15).

5. Ensemble en céramique composite selon la revendication 4, dans lequel les électrodes terminales externes (14) ne sont pas disposées aux coins de la seconde face principale du substrat en céramique (10).

6. Ensemble en céramique composite selon la revendication 5, dans lequel les coins sont plus bas que la hauteur à laquelle les électrodes terminales externes (14) sont disposées.

7. Ensemble en céramique composite selon l'une quelconque des revendications 2 à 6, dans lequel le composant monté en surface (11) est monté entre les parties de patte convexes (15) sur la seconde face principale.

8. Ensemble en céramique composite selon la revendication 7, dans lequel le composant monté en surface (11) est soutenu avec une résine (18) qui est la même que celle formant la partie de patte convexe (15).

9. Ensemble en céramique composite selon la revendication 8, dans lequel une partie arrondie est formée entre la partie de patte convexe (15) et la résine (18) revêtant le composant monté en surface (11).

10. Ensemble en céramique composite selon la revendication 8 ou 9, dans lequel la surface de la résine (18) revêtant le composant monté en surface (11) a une fente (18A).

11. Ensemble en céramique composite selon l'une quelconque des revendications 1 à 10, dans lequel un bord de la partie de patte convexe (15) est formé en une forme arrondie.

12. Ensemble en céramique composite selon l'une quelconque des revendications 1 à 11, dans lequel le conducteur de trou d'interconnexion est formé avec une résine conductrice ayant une certaine flexibilité.

13. Ensemble en céramique composite selon l'une quelconque des revendications 1 à 12, dans lequel le substrat en céramique (10) est un substrat en céramique multicouche (10) formé par laminage d'une pluralité de couches de céramique conjointement cuites à basse température.

14. Ensemble en céramique composite selon l'une quelconque des revendications 1 à 13, dans lequel le composant monté en surface (11) a des électrodes terminales externes (14) dans une matrice.
